# EUROPEAN PATENT APPLICATION

(11) **EP 0 572 177 A1**
(43) Date of publication of application: **01.12.1993**
(21) Application number: 93303929.9
(22) Date of filing: 20.05.1993
(51) Int. Cl.: H01B 3/44, B32B 27/08

(54) **Electrical insulation laminate**

(30) Priority: 28.05.1992 JP 162008/92
(71) Applicant: JUNKOSHA CO. LTD., Setagaya-ku Tokyo 156 (JP)
(72) Inventor: Yagihashi, Hideo, Hanno, Saitama 357 (JP)
(74) Representative: Horner, Martin Grenville

(57) **Abstract**

A light-weight, but strong electrical insulation tape, which is a laminate of porous polytetrafluoroethylene and polyetheretherketone.

## Description

### FIELD OF THE INVENTION

This invention relates to a laminated tape for use as electrical insulation.

### BACKGROUND OF THE INVENTION

As electrical insulation, especially for aircraft frame wire insulation, materials such as polytetrafluoroethylene (hereinafter "PTFE"), a copolymer of ethylene and tetrafluoroethylene (hereinafter "ETFE"), crosslinked ETFE, polyimide, polyester, etc. have often been used through extrusion or tape-wrap processes. Moreover, glass cloth impregnated with PTFE or continuously porous PTFE sheet impregnated in the surface portion with meltable resins have been used as substrates for printed circuit boards for high frequency applications.

However, the materials mentioned above do not have the performance characteristics required for electrical air frame wire insulation such as lightweight, high mechanical strength, heat resistance, and chemical resistance altogether at one time. That is, PTFE is not mechanically strong; ETFE and crosslinked ETFE have high specific gravity; polyimide is stiff and undergoes hydrolysis; and polyester is not highly heat resistant. Moreover, these materials except PTFE have a dielectric constant exceeding 2.1. Thus, they are not suitable for the dielectric insulation material of coaxial cables for high speed signal transmission.

Continuously porous PTFE, such as expanded PTFE, excels in the dielectric constant far less than 2.1 and low specific gravity, but is not as mechanically strong as desired in air frame electrical wiring. Thus it does not meet all the requirements together.

PTFE-impregnated glass cloths have an increased dielectric constant, so that their use as a substrate material is limited in terms of frequency. Continuously porous PTFE substrate impregnated in the surface part with meltable resins has an intermediate part or area where the resin is not filled and the dielectric constant is held low, thus it can be used as a high frequency substrate. However, due to the unfilled portion, this material can easily be deformed by mechanical stress, causing the electrical properties to change. Thus, printed circuit boards using this material need to be protected from outside stress, and their use is therefore limited.

### SUMMARY OF THE INVENTION

In consideration of the problems of prior materials mentioned above, the purpose of the present invention is to provide a flexible, electrical insulation material having characteristics desired for air frame wire insulation, such as lightweight, high mechanical strength, thermal resistance, chemical resistance, and reduced dielectric constant altogether simultaneously. Another purpose of the present invention is to provide a substrate material for use with printed circuit boards for high frequency application.

The present invention, which achieves the purposes mentioned above, is an electrical insulation material comprising a continuously porous polytetrafluoroethylene (PTFE) tape and a polyetheretherketone (PEEK) film, the latter being laminated to one or both surfaces of the former.

### BRIEF DESCRIPTION OF THE DRAWING

Figure 1 is a perspective view of an example of the electrical insulation laminate of the present invention.

Figure 2 is an A-A¹ cross section of the laminate of Figure 1.

Figure 3 is a perspective view of another example of the laminate of the present invention.

### DETAILED DESCRIPTION OF THE INVENTION

The electrical insulation laminate of the present invention can be produced by laying a PEEK film on one or both sides of a continuously porous PTFE tape, heating the combination at a temperature above the melting point of PEEK (334°C) and compressing the combination, thereby the PEEK film is melted and anchored to the numerous fine pores of the PTFE tape to provide a unified laminate.

The laminate thus obtained is lightweight, with a specific gravity from 0.5 to 2.0, has good mechanical strength, has heat resistance as high as 250°C and is not affected by most chemicals. Thus, this electrical insulation laminate satisfies the requirements for an air frame wire insulation of lightweight, high mechanical strength, heat resistance and chemical resistance simultaneously. This laminate can be slit to a narrow tape of a desired width, then wrapped around a conductor, followed by heating above the melting point of PEEK to give an insulated wire. The wire so obtained has, in addition to the excellent properties as mentioned above, crush resistance and dimensional stability.

By selecting the thickness ratio of the porous PTFE tape to the PEEK tape, the dielectric constant of this electrical insulation laminate can be varied in the range from 1.3 to 2.5. With the lower side of the dielectric constant, the laminate can be used for a dielectric of high speed signal transmission lines. Such transmission lines are crush resistant and free from an increase in the dielectric constant due to crushing, thus providing a stabilized transmission characteristic.

In addition to the application as an air frame wire insulation, the laminate of the present invention can be used for a substrate of a flexible printed circuit board or a multi-layer printed circuit board. These circuit boards can be used for high frequency applications, while offering crush resistance, low dielectric constant and lightweight.

### Example

The present invention is explained with reference to an example below, in which reference is also made to the drawings.

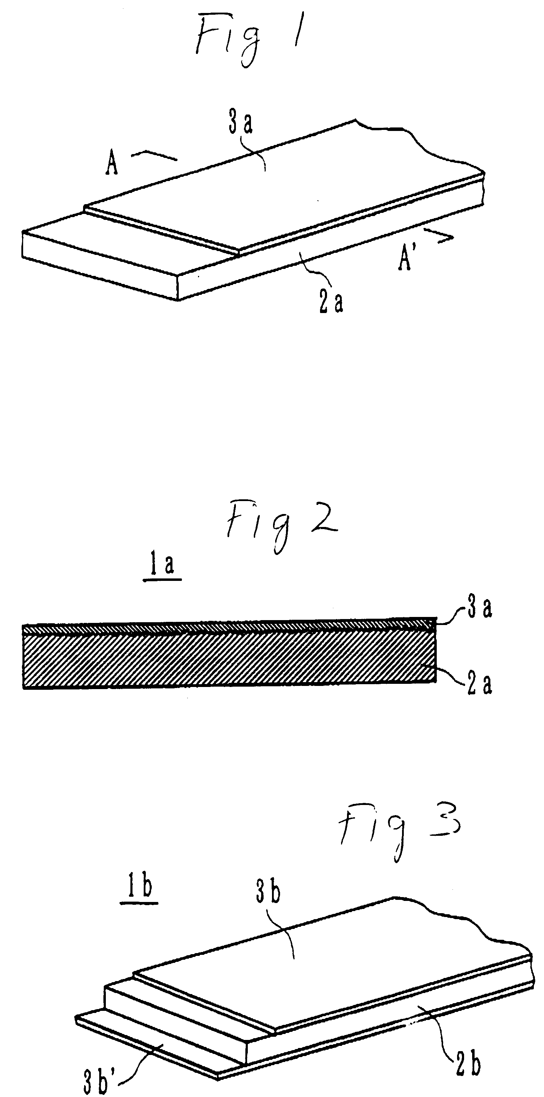

Referring to Figure 1, the electrical insulation laminate 1a was made by the following. A PEEK film 3a was laid on one side of a continuously porous expanded PTFE tape. This combination of tapes was placed between a pair of polyimide film (no shown). This combination was then put in a hot plate press (not shown), heated and compressed to produce a laminate consisting of the PEEK and PTFE tapes bonded together. The time, temperature and pressure at the time of lamination are interdependent and can be varied mostly by varying the thickness of the PEEK film 3a, and the number of layers used. The temperature used is above the melting point of PEED, which is 334°C , the pressure can range from about 1-75 kg/mm², and the time is several seconds, e.g. 30, to several minutes. For example, a PTFE tape 2a of 80 µm and a PEEK tape of 7 µm were laminated together at a temperature of about 360°C 5 kg/mm² and a compression time of about 30 seconds.

By doing this, the continuously porous PTFE tape which has a great many microscopic pores from one side to the other allows some intrusion of molten PEEK into the pore, i.e., void, spaces. Upon cooling the molten PEEK solidifies to set it to the PTFE tape by an anchoring effect as shown in Figure 2.

The electrical insulation laminate 1a of the present invention has a thermal resistance as high as around 250°C, a chemical resistance to all chemicals except sulfuric acid, a light weight (specific gravity of 0.6 - 1.8), a reduced dielectric constant (1.3 - 2.5), as well as a higher dimensional stability than the continuously porous PTFE tape alone. The tensile strength of the laminate 1a is 2.5 kg/mm² minimum. It has an elongation of 50% minimum and a dynamic cut-through resistance of 2.5 kg minimum (measured using a cutting edge radius of 25 µm). For comparison, a hot-melt polyester tape with a PVC adhesive layer has a dynamic cut-through resistance of 1.5 kg measured by the same method.

The peel strength between the PTFE tape 2a and the PEEK film 3a was 0.2 kfg/cm which is enough to accomplish a helical wrap wire insulation without delaminating during wrapping. Since the laminate is usable as long as the tape 2a and the film 3a do not slide with respect to each other, they can be partly bonded, for example, in such patterns as dots, nets, straight lines, wave lines and combination thereof.

The electrical insulation laminate 1a was slit to a desired width and wrapped around a stranded conductor (7/0.064mm) to give an insulation having an outer diameter of 0.5mm. This insulated wire was fitted in an annealed copper tube and the tube was passed through a snug constricting die to make a semi-rigid coaxial cable. The propagation delay time (Tpd) of this semi-rigid cable was 3.84 nanosecond/m. Calculated from this value, the dielectric constant (Er) of this dielectric was 1.325.

Figure 3 shows another example of the electrical insulation laminate of the present invention. On both sides of a continuously porous 80 µm PTFE tape, PEEK films 3b and 3b¹ were layered, and they were laminated under the same heat, pressure and time conditions used in the above example to give a three layer laminate 1b.

The present invention is not limited to the examples mentioned above. Parameters such as the thickness of the PTFE tape and PEEK film, number of layers laminated, lamination temperature, pressure and time can of course be varied in a wide range.

As detailed hereinabove, the electrical insulation material of the present invention has lightweight, high mechanical strength, heat resistance, chemical resistance, low dielectric constant and dimensional stability. This laminate is therefore suitable for an airframe wire insulation or high frequency printed circuit board dielectric substrate material.

## Claims

1. An electrical insulation laminate comprising a porous polytetrafluoroethylene resin tape and a polyetheretherketone film, the latter being laminated on one or both surfaces of the former.
